# EUROPEAN PATENT APPLICATION

(11) **EP 4 610 803 A1**
(43) Date of publication of application: **03.09.2025**
(21) Application number: 25159921.3
(22) Date of filing: 25.02.2025
(51) Int. Cl.: G06F 3/12, G09F 9/33, G09F 13/10, H10H 20/84, G09F 27/00

(54) **ELECTRONIC APPARATUS AND METHOD OF MANUFACTURING ELECTRONIC APPARATUS**

(30) Priority: 01.03.2024 JP 2024031549
(71) Applicant: FUJIFILM Corporation, Tokyo 106-8620 (JP)
(72) Inventor: KAYA, Akimasa, Saitama 331-9624 (JP)
(74) Representative: Meissner Bolte Partnerschaft mbB

(57) **Abstract**

Provided are an electronic apparatus and a method of manufacturing an electronic apparatus, which are capable of suppressing a deterioration in exterior characteristics while ensuring transmission of light from a light-emitting unit.

An electronic apparatus includes: a light-emitting unit configured to emit light to an outside; and an exterior body including a first member that is a member having a transmission portion that allows transmission of the light emitted from the light-emitting unit and having a coating film on a surface, and a second member that is a member disposed adjacent to the first member and formed of a material having lower light transmittance than the first member, in which a thickness of the coating film in a contact portion between the first member and the second member is greater than a thickness of the coating film in the transmission portion.

## Description

### BACKGROUND OF THE INVENTION

### 1. Field of the Invention

The present disclosed technology relates to an electronic apparatus and a method of manufacturing an electronic apparatus.

### 2. Description of the Related Art

JP3196184Y discloses a battery in which an electronic circuit board in which a charging/discharging module comprising a secondary battery is mounted is accommodated in a housing consisting of a front case and a rear case, the secondary battery is charged by an external power supply, power of the secondary battery can be supplied to a portable electronic apparatus, a decorative LED lamp is mounted on the electronic circuit board, at least any one of the front case or the rear case is configured to allow transmission of light emitted from the decorative LED lamp, and the decorative LED lamp is faced inside at least any one of the front case or the rear case configured to allow the transmission of the light emitted from the decorative LED lamp.

JP2012-156364A discloses a portable electronic apparatus comprising: a falling detection unit that detects that the portable electronic apparatus has fallen into water; a light emitter that is provided inside a housing; and a light emission control circuit that causes the light emitter to emit light in a case in which the falling detection unit detects the fall into water, in which a translucent portion is provided in a part of the housing.

JP2010-96968A discloses a display device comprising: an organic EL panel in which a first electrode, an organic layer having at least a light-emitting layer, and a second electrode are laminated and formed on a support substrate; a case body that accommodates the organic EL panel and has a display unit through which a light emission display image from the organic EL panel is transmitted; and a gel-like member having light transmittance that is disposed between the organic EL panel and the display unit.

JP2003-16865A discloses a portable terminal device comprising: a key sheet having a plurality of operation keys, a front case that is disposed on the key sheet and into which the operation keys are inserted, and an illumination unit that illuminates the operation keys of the key sheet, in which the illumination unit is configured such that light emitted from a light source is transmitted through the front case to illuminate the operation keys.

JP2001-330898A discloses an instant printer comprising: a loading chamber that stores a film pack in which unexposed instant films are stacked and in which a transport port for transporting the instant films one by one is formed; a first transport unit that transports the instant films transported from the transport port in a bent state; a second transport unit that transports the instant films transported by the first transport unit along an outer peripheral portion of the loading chamber; an exposure head that is disposed in the vicinity of the transport port and that irradiates the instant films transported by the first transport unit with light; and a spreading roller that spreads a developer by pressing the instant films transported by the second transport unit.

### SUMMARY OF THE INVENTION

In the electronic apparatus, a light-emitting unit may be provided in an exterior body in order to display an operation state or improve a user experience. In the exterior body, a side on which the light-emitting unit is provided is formed of a material having high transmittance in order to transmit light from the light-emitting unit. On the other hand, a side on which the light-emitting unit is not provided is formed of a material having low transmittance. This configuration is to suppress the entry of unnecessary external light into the inside of the exterior body.

However, in a case in which the exterior body of the electronic apparatus is manufactured by combining two types of members having different optical characteristics, the members are noticeable as separate components in a portion in which the members are in contact with each other, and thus the exterior body as a whole may lack a sense of unity and the exterior characteristics may be impaired.

Therefore, the present disclosed technology provides an electronic apparatus and a method of manufacturing an electronic apparatus, which are capable of suppressing a deterioration in exterior characteristics while ensuring transmission of light from a light-emitting unit.

A first aspect according to the present disclosed technology relates to an electronic apparatus comprising: a light-emitting unit configured to emit light to an outside; and an exterior body including a first member that is a member having a transmission portion that allows transmission of the light emitted from the light-emitting unit and having a coating film on a surface, and a second member that is a member disposed adjacent to the first member and formed of a material having lower light transmittance than the first member, in which a thickness of the coating film in a contact portion between the first member and the second member is greater than a thickness of the coating film in the transmission portion.

A second aspect according to the present disclosed technology relates to the electronic apparatus according to the first aspect, in which the first member has a substrate, and the coating film is formed on a surface of the substrate.

A third aspect according to the present disclosed technology relates to the electronic apparatus according to the second aspect, in which the substrate is formed of a translucent material.

A fourth aspect according to the present disclosed technology relates to the electronic apparatus according to the first aspect, in which the first member has a bottom plate portion on which the transmission portion is formed and a side wall portion that is erected from a peripheral edge of the bottom plate portion toward the second member, and the side wall portion is the contact portion.

A fifth aspect according to the present disclosed technology relates to the electronic apparatus according to the first aspect, in which the second member is formed of a non-transparent material.

A sixth aspect according to the present disclosed technology relates to the electronic apparatus according to the fifth aspect, in which the non-transparent material is a resin material containing titanium oxide.

A seventh aspect according to the present disclosed technology relates to the electronic apparatus according to the first aspect, in which the light-emitting unit includes an LED light source.

An eighth aspect according to the present disclosed technology relates to the electronic apparatus according to the first aspect, in which the thickness of the coating film in the contact portion is 1.5 times or more the thickness of the coating film in the transmission portion.

A ninth aspect according to the present disclosed technology relates to the electronic apparatus according to the first aspect, in which the electronic apparatus has a printer function, and a space in which a film containing a photosensitive material is accommodatable is formed in the second member.

A tenth aspect according to the present disclosed technology relates to a method of manufacturing an electronic apparatus including a light-emitting unit configured to emit light to an outside, and an exterior body including a first member that is a member having a transmission portion that allows transmission of the light emitted from the light-emitting unit and having a coating film on a surface, and a second member that is a member disposed adjacent to the first member and formed of a material having lower light transmittance than the first member, the method comprising: preparing the first member; and providing the coating film in the first member at a contact portion with the second member to be thicker than the coating film in the transmission portion.

### BRIEF DESCRIPTION OF THE DRAWINGS

Fig. 1 is a conceptual diagram illustrating an example of a configuration of an electronic apparatus according to an embodiment.
Fig. 2 is a plan view illustrating an example of the configuration of the electronic apparatus according to the embodiment.
Fig. 3 is a cross-sectional view illustrating an example of the configuration of the electronic apparatus according to the embodiment.
Fig. 4 is a conceptual diagram illustrating an example of the configuration of the electronic apparatus according to the embodiment.
Fig. 5 is a conceptual diagram illustrating an example of the configuration of the electronic apparatus according to the embodiment.
Fig. 6 is a conceptual diagram illustrating an example of the configuration of the electronic apparatus according to the embodiment.
Fig. 7 is a cross-sectional view illustrating an example of the configuration of the electronic apparatus according to the embodiment.
Fig. 8 is a side view illustrating an example of the configuration of the electronic apparatus according to the embodiment.
Fig. 9 is a flowchart illustrating an example of a processing process according to the embodiment.
Fig. 10 is a flowchart illustrating an example of a painting process according to the embodiment.
Fig. 11 is a conceptual diagram illustrating an example of the configuration of the electronic apparatus according to the embodiment.

### DESCRIPTION OF THE PREFERRED EMBODIMENTS

An example of an embodiment of an electronic apparatus 10 according to the present disclosed technology will be described with reference to the accompanying drawings.

Hereinafter, for convenience of description, a width direction, a front-rear direction, and a height direction of the electronic apparatus 10 are indicated by three arrows X, Y, and Z. First, the height direction is indicated by the arrow Z, a direction indicated by the arrow Z is referred to as an up direction of the electronic apparatus 10, and an opposite direction thereof is referred to as a down direction. The width direction is indicated by the arrow X orthogonal to the arrow Z, a direction indicated by the arrow X is referred to as a right direction of the electronic apparatus 10, and an opposite direction thereof is referred to as a left direction. The front-rear direction is indicated by the arrow Y in a direction orthogonal to the arrow Z and the arrow X, a direction indicated by the arrow Y is referred to as a front direction of the electronic apparatus 10, and an opposite direction thereof is referred to as a rear direction. In addition, in the following description, the expressions using the side, such as an upper side, a lower side, a left side, a right side, a front side, and a rear side, have the same meaning as the expressions using the direction.

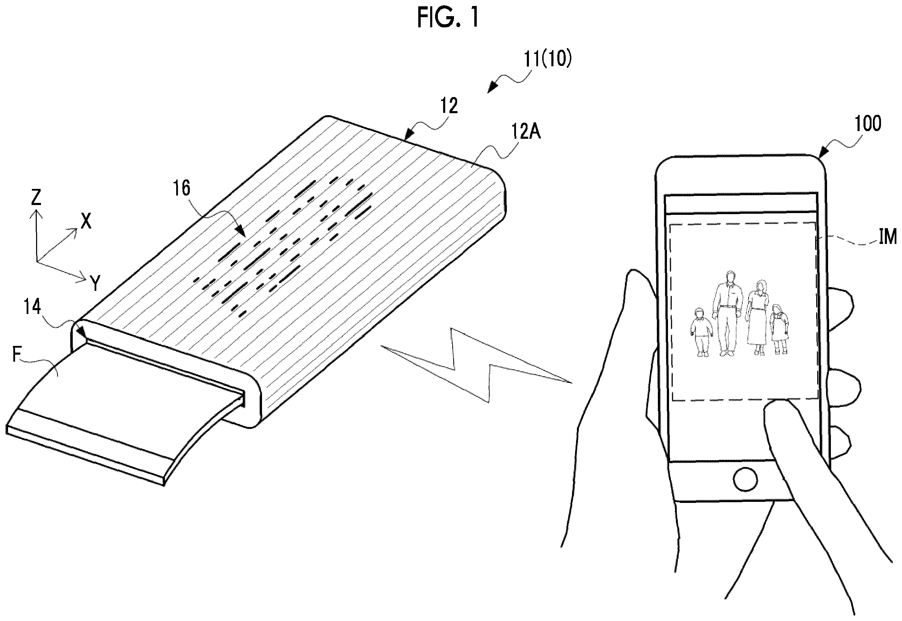

As illustrated in Fig. 1 as an example, the electronic apparatus 10 has, for example, a printer function. The electronic apparatus 10 is, for example, a portable electronic apparatus. The electronic apparatus 10 is, for example, a mobile printer. Hereinafter, for convenience of description, the embodiment will be described with the mobile printer 11 as an example. The electronic apparatus 10 is an example of an "electronic apparatus" according to the present disclosed technology.

The mobile printer 11 can communicate with an external device. In the example illustrated in Fig. 1, the mobile printer 11 can communicate with a smartphone 100. Examples of a communication method include wireless communication (for example, Bluetooth (registered trademark)), but wired communication may be used. The mobile printer 11 receives image data IM transmitted from the smartphone 100 and prints a subject image shown by the received image data IM on a film F. The film F is, for example, a film containing a photosensitive material (so-called instant film). The film F is an example of a "film" according to the present disclosed technology.

The mobile printer 11 comprises an exterior body 12. In the example illustrated in Fig. 1, the exterior body 12 has a rectangular parallelepiped-shaped housing structure having a longitudinal direction in an X direction. The exterior body 12 accommodates, inside, electronic components and the like for implementing the printer function and other functions of the mobile printer 11. In addition, for example, the printed film F is discharged from an outlet 14 provided on a left side surface of the exterior body 12. The exterior body 12 is an example of an "exterior body" according to the present disclosed technology.

A display unit 16 is formed on the exterior body 12. The display unit 16 shows at least one of a character, a symbol, or a figure on a surface of the exterior body 12. In the example illustrated in Fig. 1, the display unit 16 is formed on an upper surface 12A of the exterior body 12. In the example illustrated in Fig. 1, the display unit 16 shows the characters "ABCD". Examples of the content shown by the display unit 16 include a company name, a product name, a personal name, a catchphrase, a logo mark, and/or a pictogram. In addition, examples of the content shown by the display unit 16 may include a symbol (for example, an arrow indicating a film discharge direction) or a figure (for example, a mark of a power button) for describing an operation of the mobile printer 11.

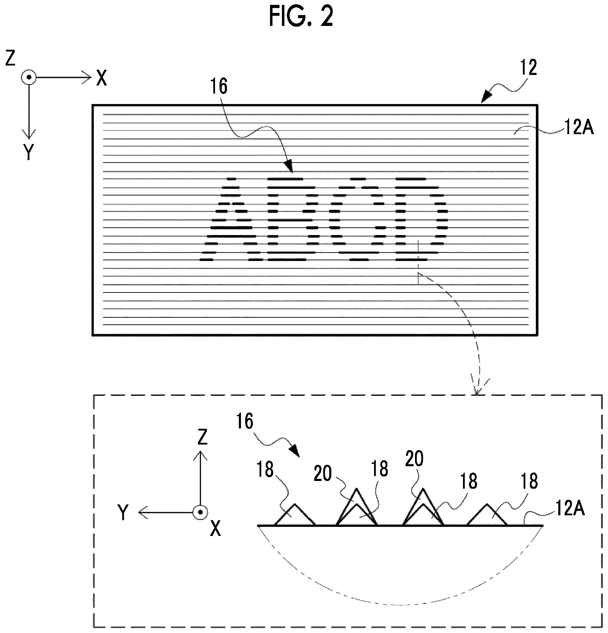

As illustrated in Fig. 2 as an example, a linear stripe pattern is formed on the exterior body 12 along the longitudinal direction (here, the X direction). Specifically, the stripe pattern consisting of periodic recessed and protruding portions is formed on the surface of the exterior body 12. Hereinafter, the stripe pattern is described with the upper surface 12A on the surface of the exterior body 12 as an example, but it goes without saying that the stripe pattern may be formed on other surfaces of the exterior body 12 in the same manner.

In a case of being viewed from a cross section having the longitudinal direction as a normal direction (in a cross-sectional view), protruding portions 18 are periodically formed on the upper surface 12A of the exterior body 12. In a cross-sectional view, the protruding portion 18 has a triangular shape, and a portion at a vertex is continuous along the longitudinal direction, whereby the linear stripe pattern is formed. As described above, the protruding portions 18 are periodically present, and thus the stripe pattern consisting of periodic recessed and protruding portions is formed.

Here, the display unit 16 shows at least one of the character, the symbol, or the figure due to a difference in a three-dimensional shape from a periphery on the surface of the exterior body 12. In the example illustrated in Fig. 2, the display unit 16 protrudes to an outer side (here, an upper side) of the exterior body 12 rather than the periphery. As a result, the difference in the three-dimensional shape from the periphery is generated. Specifically, in the above-described stripe pattern, a portion corresponding to the display unit 16 is the protruding portion 20 that is higher than the protruding portion 18 present on the periphery. That is, in the example illustrated in Fig. 2, the difference in the three-dimensional shape is a difference in a height of the protruding portion of the stripe pattern.

The difference in the three-dimensional shape between the display unit 16 and the other region causes a difference in a way of reflecting natural light (here, ambient light). In this way, the display unit 16 can be visually recognized due to the difference in the three-dimensional shape from the periphery (here, the characters "ABCD" appear to be floating).

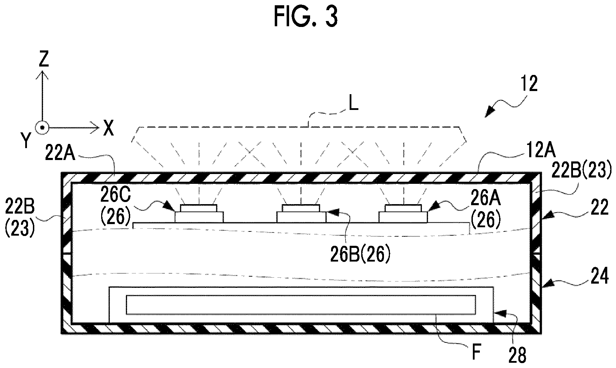

As illustrated in Fig. 3 as an example, the exterior body 12 includes a first member 22 and a second member 24 disposed adjacent to the first member 22. The first member 22 is, for example, a cover member that constitutes the upper side of the exterior body 12, and the second member 24 is, for example, a cover member that constitutes a lower side of the exterior body 12. The mobile printer 11 comprises a light-emitting unit 26 inside the exterior body 12. The light-emitting unit 26 is provided at a position facing the display unit 16 inside the exterior body 12. The light-emitting unit 26 can emit emission light L to the outside through the exterior body 12. The emission light L is, for example, light including a wavelength in a visible light range. The light-emitting unit 26 is an example of a "light-emitting unit" according to the present disclosed technology.

In the example illustrated in Fig. 3, the light-emitting unit 26 includes, for example, light-emitting diode (LED) light sources 26A to 26C. The LED light sources 26A to 26C are linearly arranged in an order from a right side inside the exterior body 12. Here, the form example is described in which the three LED light sources 26A to 26C are disposed, but this is merely an example, and two or less or four or more LED light sources may be used. In addition, a disposition interval of the LED light sources, positions at which the LED light sources are disposed, and a disposition method (for example, disposing the LED light sources in a circular shape or disposing the LED light sources at positions of vertices of a quadrangle) can also be set as appropriate. In addition, each of the LED light sources 26A to 26C includes RGB light-emitting elements, and a color and a light amount of the emission light L can be changed by controlling a light emission aspect of each light-emitting element. The LED light sources 26A to 26C are examples of an "LED light source" according to the present disclosed technology.

In addition, in the example illustrated in Fig. 3, the light-emitting unit 26 is accommodated inside the first member 22 that constitutes an upper portion of the exterior body 12. The first member 22 comprises a contact portion 23 as a portion in contact with the second member 24. Specifically, the first member 22 includes a bottom plate portion 22A as a plate-shaped portion having a plate thickness direction in the height direction, and a side wall portion 22B that is erected from a peripheral edge of the bottom plate portion 22A along the height direction. Here, the side wall portion 22B is erected toward the second member 24 in a state in which the first member 22 and the second member 24 are combined. Although the details will be described later, the side wall portion 22B is in contact with the second member 24, and the side wall portion 22B also functions as the contact portion 23.

The light-emitting unit 26 is provided at a position facing an inner surface of the bottom plate portion 22A. The emission light L from the light-emitting unit 26 is transmitted through the bottom plate portion 22A and is emitted to the outside of the exterior body 12. Here, the transmission of the emission light L includes that the emission light L is scattered in the exterior body 12 and is emitted to the outside. Here, since the exterior body 12 is formed of a resin material, the emission light L is scattered in a case of passing through the bottom plate portion 22A, and an emission range of the emission light L to the outside is widened. The first member 22 is an example of a "first member" according to the present disclosed technology. The bottom plate portion 22A is an example of a "bottom plate portion" according to the present disclosed technology, and the side wall portion 22B is an example of a "side wall portion" according to the present disclosed technology.

In addition, a space 28 in which the film F is accommodatable is formed in the second member 24 constituting a lower portion of the exterior body 12. The film F is accommodated inside the space 28 via a cover (not illustrated). Here, for convenience of description, one film F is illustrated, but it goes without saying that a plurality of films F may be accommodated in the space 28. The space 28 can be open with respect to a lower surface of the exterior body 12. In other words, the light-emitting unit 26 is provided at a position facing the display unit 16 formed on a surface (here, the upper surface) of the exterior body 12 opposite to a side on which the film F is accommodated. The second member 24 also has the same shape as the first member 22. The second member 24 is an example of a "second member" according to the present disclosed technology.

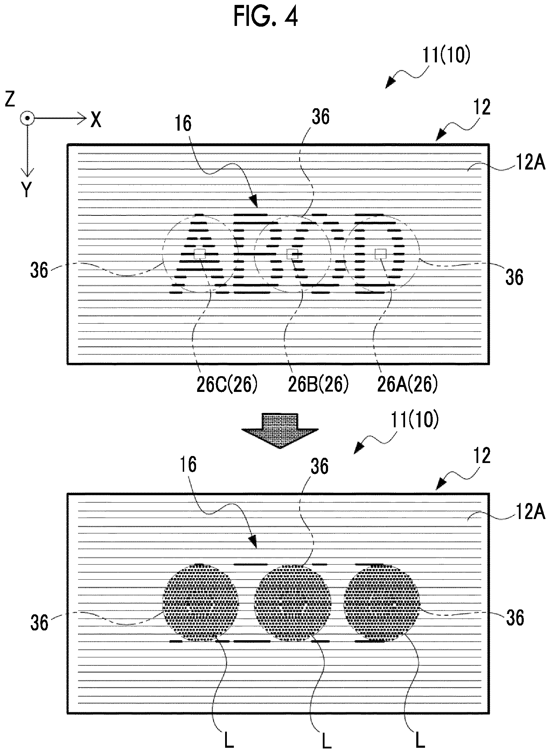

As illustrated in Fig. 4 as an example, a transmission portion 36, which is a region through which the emission light L is transmitted through the exterior body 12, is determined by a distance between the light-emitting unit 26 and the inner surface of the exterior body 12 and a spread angle of the emission light L. Specifically, the transmission portion 36 is determined by the distance between the LED light sources 26A to 26C of the light-emitting unit 26 and an inner surface 22A1 of the bottom plate portion 22A and the spread angle of the emission light L from the LED light sources 26A to 26C. In other words, the first member 22 of the exterior body 12 has the transmission portion 36 that allows the transmission of the emission light L from the light-emitting unit 26. The transmission portion 36 is an example of a "transmission portion" according to the present disclosed technology.

In the mobile printer 11, the light-emitting unit 26 may emit light (for example, light up on or blink). Accordingly, it is possible to notify of an operation state of the mobile printer 11 or to improve a user experience (for example, to improve the fun that a user feels during use). Here, in a case in which the exterior body 12 of the mobile printer 11 is viewed in a plan view (here, in a case of being viewed from the upper surface), the light emission via the light-emitting unit 26 overlaps a position of the display unit 16 (that is, the light-emitting unit 26 faces the display unit 16). In such a case, it is difficult to see the display unit 16 due to the light emission of the light-emitting unit 26. That is, in a case in which the light-emitting unit 26 emits light, the emission light L transmitted through the exterior body 12 is easily visually recognized, and reflected light (for example, reflected light caused by the difference in three-dimensional shape from the periphery) in the display unit 16 is not easily visually recognized. As a result, the visibility of the display unit 16 is decreased.

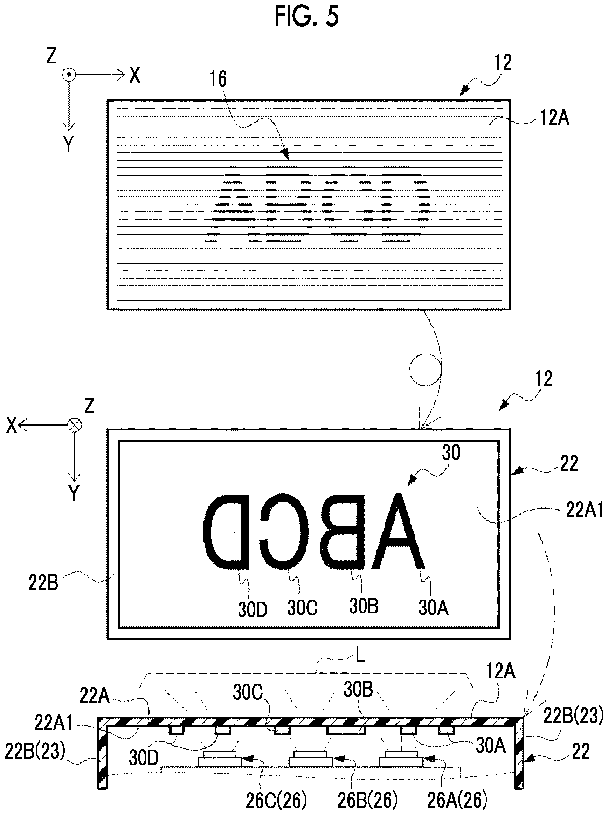

Therefore, as illustrated in Fig. 5 as an example, in the present embodiment, in the exterior body 12, a difference in transmittance of the emission light L emitted from the light-emitting unit 26 is generated between a region corresponding to the display unit 16 and a region on the periphery. Specifically, a transmission suppression layer 30 containing a material having lower light transmittance than the periphery is formed on the inner surface of the exterior body 12. More specifically, the transmission suppression layer 30 is formed on the inner surface 22A1 of the bottom plate portion 22A in the first member 22 of the exterior body 12. The transmission suppression layer 30 is formed in the region corresponding to the display unit 16. The region corresponding to the display unit 16 is, for example, a back surface of the display unit 16, and is a range having the same size as the display unit 16. In the example illustrated in Fig. 5, transmission suppression layers 30A, 30B, 30C, and 30D having shapes in which the characters "ABCD" shown by the display unit 16 are inverted are formed. The region corresponding to the display unit 16 need not be a range having the same size as the display unit 16, and the size may be changed as appropriate.

The transmission suppression layers 30A, 30B, 30C, and 30D are formed on the inner surface 22A1 of the first member 22 by printing. Specifically, the transmission suppression layers 30A, 30B, 30C, and 30D are formed by printing using a coating material containing a material that absorbs the wavelength in the visible light range. For example, the transmission suppression layers 30A, 30B, 30C, and 30D are printed using a black coating material. A part of the emission light L is absorbed or reflected due to the interaction with the transmission suppression layer 30. In this way, the transmission of the emission light L in the region corresponding to the display unit 16 is suppressed.

As described above, the light-emitting unit 26 is provided at a position facing the display unit 16. In addition, inside the exterior body 12, the transmission suppression layer 30 is formed in the region corresponding to the display unit 16. Therefore, the transmission of a part of the emission light L from the light-emitting unit 26 is suppressed by the transmission suppression layer 30. Here, a part of the emission light L is absorbed by the black coating material included in the transmission suppression layer 30. In addition, in the example illustrated in Fig. 5, in a case in which the first member 22 is viewed from the inner surface side (here, in a case of being viewed from below), the transmission suppression layers 30A, 30B, 30C, and 30D have the shapes in which the characters "ABCD" are inverted. Therefore, in the region having the shapes in which the characters of "ABCD" are inverted, the transmission of the emission light L through the exterior body 12 is suppressed.

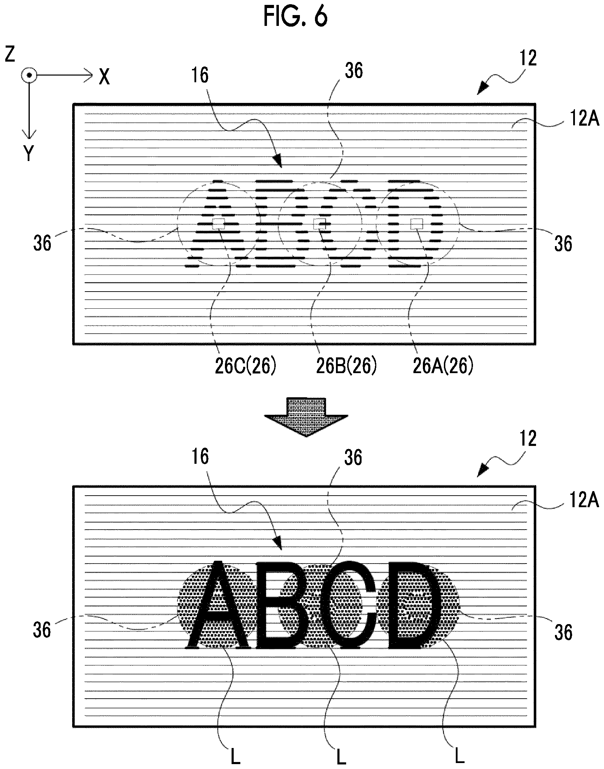

As illustrated in Fig. 6 as an example, in the mobile printer 11, in a case in which the light-emitting unit 26 emits light, as described above, the transmission of the emission light L is suppressed by the transmission suppression layer 30 provided in the region corresponding to the display unit 16. As a result, the emission light L is less likely to be transmitted through the display unit 16, and thus the display unit 16 is easily visually recognized. In the example illustrated in Fig. 6, the characters "ABCD" of the display unit 16 are easily visually recognized by the transmission suppression layer 30 having the shapes in which the characters "ABCD" are inverted. In addition, in a range illuminated with the emission light L, the content (here, the characters "ABCD") indicated by the transmission suppression layer 30 floats as a shadow, and the designability is improved.

A portion of the exterior body 12 facing the light-emitting unit 26 is required to contain a material having relatively high transmittance in order to transmit the emission light L from the light-emitting unit 26. On the other hand, a portion opposite to the portion facing the light-emitting unit 26 is required to contain a material having relatively low transmittance. This configuration is to suppress the entry of unnecessary external light into the inside of the exterior body 12.

In a case in which the exterior body 12 is formed by combining two types of members having different optical characteristics (for example, light transmittance), a difference in the optical characteristics makes it noticeable that the two types of members are separate components in a portion in which the two types of members are in contact with each other. As a result, the exterior body 12 may lack a sense of unity as a whole and may impair the exterior characteristics.

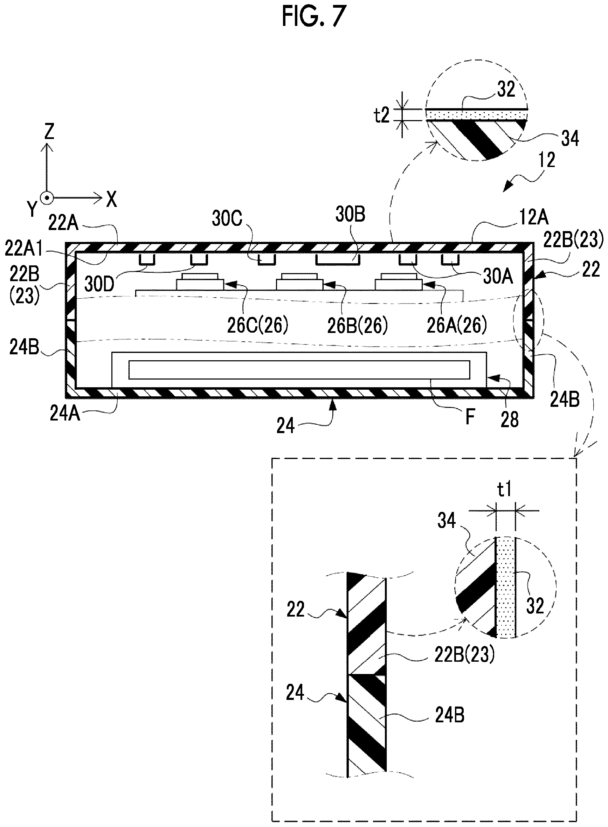

Therefore, as illustrated in Fig. 7 as an example, a thickness of a coating film 32 is adjusted in the first member 22 of the exterior body 12. The first member 22 includes the coating film 32 and a substrate 34. The coating film 32 is formed on a surface of the substrate 34. The substrate 34 is formed of a translucent material. Here, the translucent material is a material that allows the transmission of the light while scattering the light. The substrate 34 is, for example, a milky white resin. In addition, the coating film 32 is a film formed by fixing the coating material to the surface of the substrate 34, and the type of the coating material is set as appropriate in accordance with a color variation of the exterior body 12. As described above, the emission light L from the light-emitting unit 26 is emitted to the outside through the first member 22. Since the first member 22 is formed of the translucent material, the emission light L is easily emitted to the outside of the exterior body 12, and the emission light L is easily visually recognized. The coating film 32 is an example of a "coating film" according to the present disclosed technology. The substrate 34 is an example of a "substrate" according to the present disclosed technology.

The coating film 32 has a thickness t1 in the side wall portion 22B of the first member 22. On the other hand, the coating film 32 has a thickness t2 in the bottom plate portion 22A of the first member 22. In addition, the thickness t1 of the coating film 32 in the side wall portion 22B is greater than the thickness t2 of the coating film 32 in the bottom plate portion 22A. In other words, in the transmission portion 36 (see Fig. 4) through which the emission light L is transmitted in the bottom plate portion 22A, the thickness t2 of the coating film 32 is less than the thickness t1 of the coating film 32 in the side wall portion 22B.

Specifically, the thickness t1 of the coating film 32 in the side wall portion 22B is 1.5 times or more the thickness t2 of the coating film 32 in the bottom plate portion 22A. More specifically, the thickness t1 is, for example, about 20 µm, and the thickness t2 is, for example, about 10 to 12 µm.

The second member 24 includes a bottom plate portion 24A and a side wall portion 24B that is erected from a peripheral edge of the bottom plate portion 24A along the height direction. The second member 24 is formed of a material having lower light transmittance than the first member 22. Specifically, the second member 24 is formed of a non-transparent material. Here, the non-transparent material is a material that cuts light. Specifically, the non-transparent material is, for example, a material in which titanium oxide particles are dispersed in a resin as a base material. That is, the second member 24 is formed of, for example, a resin containing titanium oxide. As described above, the space 28 in which the film F is accommodated is formed in the second member 24. Since the second member 24 is formed of the non-transparent material, the entry of the external light into the inside of the second member 24 is suppressed.

The first member 22 and the second member 24 are joined in a state of being adjacent to each other. Further, the first member 22 is in contact with the second member 24 via the contact portion 23. In the example illustrated in Fig. 7, the side wall portion 22B of the first member 22 and the side wall portion 24B of the second member 24 are in contact with each other. That is, in the first member 22, the side wall portion 22B is the contact portion 23. Specifically, the lower surface of the side wall portion 22B of the first member 22 and the upper surface of the side wall portion 24B of the second member 24 are in contact with each other. Then, as described above, the thickness t1 of the coating film 32 in the side wall portion 22B is greater than the thickness t2 of the coating film 32 in the bottom plate portion 22A. That is, the thickness t1 of the coating film 32 in the contact portion 23 is greater than the thickness t2 of the coating film 32 in the transmission portion.

The first member 22 and the second member 24 are joined to each other in a state in which the side wall portion 22B and the side wall portion 24B are in contact with each other. The method of joining the first member 22 and the second member 24 is not particularly limited, and may be, for example, mechanical fastening in which a fixing unit for fitting a claw for fixing into a hole and screwing are combined, or may be joined by an adhesive, ultrasonic welding, or the like.

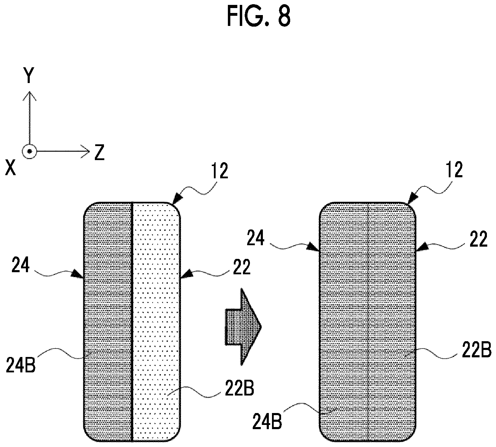

As an example, a case is considered in which the thickness t1 of the coating film 32 in the side wall portion 22B of the first member 22 (hereinafter, simply referred to as a coating film thickness t1) is less than the thickness t2 of the coating film 32 in the bottom plate portion 22A of the first member 22 (hereinafter, simply referred to as a coating film thickness t2), as illustrated on the left side of Fig. 8. In such a case, in a portion (here, the side wall portion 22B and the side wall portion 24B) in which the first member 22 and the second member 24 are in contact with each other, the difference in the light transmittance makes it noticeable that the first member 22 and the second member 24 are separate components.

On the other hand, as illustrated on the right side of Fig. 8, a case is considered in which the coating film thickness t1 in the side wall portion 22B of the first member 22 is greater than the coating film thickness t2 in the bottom plate portion 22A of the first member 22. In such a case, the light transmittance of the side wall portion 22B of the first member 22 is close to the light transmittance of the side wall portion 24B of the second member 24, so that a difference between the first member 22 and the second member 24 is less noticeable. As a result, a sense of unity of the entire exterior body 12 as a whole is increased, and the exterior characteristics are improved.

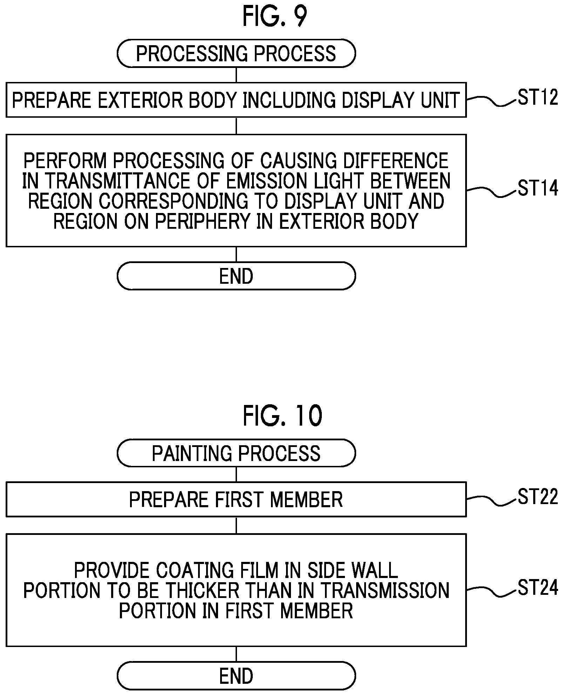

Hereinafter, a processing process and a painting process according to the present embodiment will be described with reference to Figs. 9 and 10. The processing process and the painting process are parts of a manufacturing process of the mobile printer 11. The flow of the painting process illustrated in Fig. 10 is an example of a "method of manufacturing an electronic apparatus" according to the present disclosed technology.

As illustrated in Fig. 9 as an example, in the processing process, first, in step ST12, the exterior body 12 including the display unit 16 is prepared. After the process of the step in step ST12 is performed, the processing process proceeds to step ST14.

In step ST14, processing of causing the difference in the transmittance of the light L (that is, the emission light L) emitted from the light-emitting unit 26 is performed in the region corresponding to the display unit 16 of the exterior body 12. Specifically, the transmission suppression layer 30 is formed by printing in a region corresponding to the display unit 16 of the exterior body 12 on the inner surface of the exterior body 12. After the process of the step in step ST14 is performed, the processing process ends.

As illustrated in Fig. 10 as an example, in the painting process, first, in step ST22, the first member 22 of the exterior body 12 is prepared. After the process of the step in step ST22 is performed, the painting process proceeds to step ST24.

In step ST24, in the first member 22, the coating film 32 of the side wall portion 22B is provided to be thicker than the coating film 32 of the bottom plate portion 22A. After the process of the step in step ST24 is performed, the painting process ends.

As described so far, the electronic apparatus 10 according to the present embodiment is provided with the light-emitting unit 26 that can emit the light L to the outside and the exterior body 12. The exterior body 12 includes the first member 22 and the second member 24. The first member 22 includes the transmission portion 36 that transmits the light emitted from the light-emitting unit 26, and has the coating film 32 on the surface thereof. Further, the second member 24 is disposed adjacent to the first member 22 and is formed of a material having lower light transmittance than the first member 22. The thickness of the coating film 32 in the contact portion 23 between the first member 22 and the second member 24 is greater than the thickness of the coating film 32 in the transmission portion 36. As a result, the appearance of the contact portion 23 is close to the second member 24 having lower light transmittance, and thus, in the exterior body 12, the deterioration in the exterior characteristics of the contact portion 23 is suppressed while transmitting the light L from the light-emitting unit 26.

In addition, in the electronic apparatus 10 according to the present embodiment, the first member 22 includes the substrate 34, and the coating film 32 is formed on the surface of the substrate 34. As a result, it is possible to achieve both the adjustment of the appearance of the contact portion 23 and the adjustment of a degree of transmission of the light L from the light-emitting unit 26 by controlling the thickness of the coating film 32. For example, it is easy to achieve both the adjustment of the appearance and the adjustment of the degree of transmission as compared to a case in which the appearance and the degree of transmission are adjusted by partially changing the plate thickness and the material of the first member 22.

In addition, in the electronic apparatus 10 according to the present embodiment, the substrate 34 is formed of the translucent material. Since the substrate 34 is the translucent material, it is easy to adjust the appearance of the contact portion 23 by the coating film 32 as compared to a case in which the substrate 34 is a transparent material. For example, in a case in which the substrate 34 is the transparent material, it is difficult to make the appearance close to the second member 24 unless the coating film 32 is made considerably thick. In addition, in a case in which the coating film 32 is excessively thick, it is difficult to transmit the emission light L from the transmission portion 36, and the visibility of the light emission is decreased. In the present configuration, since the coating film 32 is formed on the surface of the substrate 34 of the translucent material, it is easy to achieve both the adjustment of the appearance and the adjustment of the degree of transmission.

In addition, in the electronic apparatus 10 according to the present embodiment, the first member 22 of the exterior body 12 includes the bottom plate portion 22A and the side wall portion 22B. The transmission portion 36 is formed in the bottom plate portion 22A. In addition, the side wall portion 22B is referred to as the contact portion 23. As a result, since the contact portion 23 and the transmission portion 36 are provided at different portions of the first member 22, it is difficult to recognize the difference in the thickness of the coating film 32. As a result, it is possible to suppress the deterioration in the exterior characteristics of the electronic apparatus 10.

In addition, in the electronic apparatus 10 according to the present embodiment, the second member 24 is formed of the non-transparent material. Since the exterior body 12 is formed of the non-transparent material, the entry of unnecessary external light into the exterior body 12 is suppressed. In addition, in a case in which the second member 24 is formed of the non-transparent material, the difference in the appearance from the first member 22 is likely to be noticeable, but in the present configuration, the thickness of the coating film 32 in the contact portion 23 is greater than the thickness of the coating film 32 in the transmission portion 36. As a result, the appearance of the contact portion 23 is close to the second member 24 formed of the non-transparent material, and thus the deterioration in the exterior characteristics of the contact portion 23 is suppressed in the exterior body 12.

Further, in the electronic apparatus 10 according to the present embodiment, the non-transparent material is a resin material containing titanium oxide. In a case in which the non-transparent material is the resin material containing titanium oxide, it is easy to adjust the tint while improving the light shielding properties. In addition, even in a case in which the resin material containing titanium oxide is used, the difference in the appearance between the first member 22 and the second member 24 is likely to be noticeable, but, with the present configuration, the deterioration in the exterior characteristics of the contact portion 23 can be suppressed.

In addition, in the electronic apparatus 10 according to the present embodiment, the light-emitting unit 26 includes the LED light sources 26A to 26C. Since the LED light sources 26A to 26C are point light sources, the light can be diffused by the transmission portion 36, and thus the emission light L from the light-emitting unit 26 can be emitted over a wider range. In addition, in a case in which each of the LED light sources 26A to 26C includes the RGB light-emitting elements, the light is scattered by the transmission portion 36, and thus the deviation of the light emission position due to the deviation of the position of each light-emitting element can be absorbed.

In addition, in the electronic apparatus 10 according to the present embodiment, the thickness t1 of the coating film 32 in the contact portion 23 is set to be 1.5 times or more the thickness t2 of the coating film 32 in the transmission portion 36. By setting the thickness t1 of the coating film 32 in the contact portion 23 to be 1.5 times or more the thickness in the transmission portion 36, the appearance of the first member 22 and the second member 24 can be made similar to each other, and the deterioration in the exterior characteristics of the contact portion 23 can be suppressed.

In addition, in the electronic apparatus 10 according to the present embodiment, the electronic apparatus 10 has the printer function. In addition, the space 28 in which the film F containing the photosensitive coating material is accommodatable is formed in the second member 24. Therefore, the film F is accommodated in the space 28 formed by the second member 24, and thus the influence of the external light on the film F (for example, unintended photosensitization) is suppressed.

### Modification Example

In the above-described embodiment, the form example is described in which the transmission suppression layer 30 is formed by printing, but the present disclosed technology is not limited to this. In the present modification example, the transmission suppression layer 30 is formed by attaching the seal member 40.

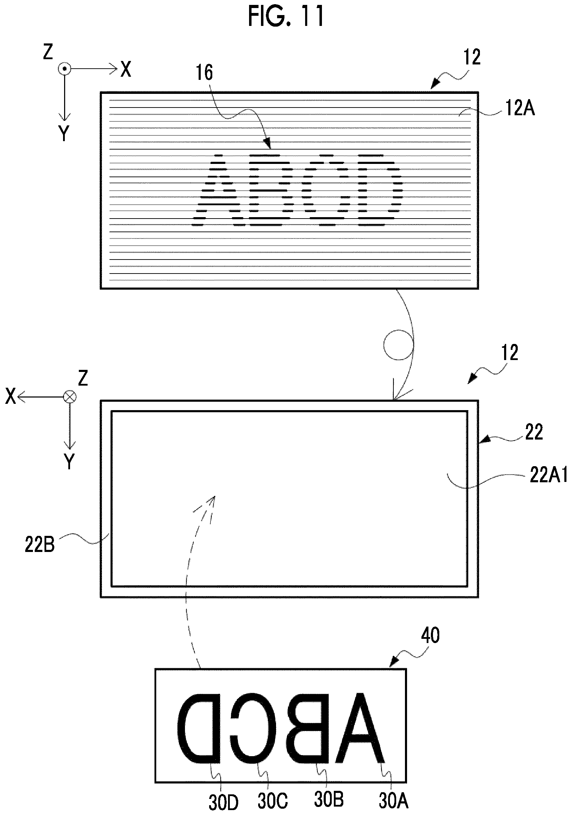

As illustrated in Fig. 11 as an example, in the present modification example, in the exterior body 12, the transmission suppression layer 30 containing a material having lower light transmittance than the periphery is formed on the inner surface of the exterior body 12. Specifically, the seal member 40 is attached to the inner surface 22A1 of the bottom plate portion 22A in the first member 22 of the exterior body 12. The seal member 40 has, for example, a laminated structure and includes a pressure-sensitive adhesive layer, the transmission suppression layer 30, and a coating layer. The seal member 40 is attached to the exterior body 12 via the pressure-sensitive adhesive layer. The transmission suppression layer 30 corresponding to the content shown by the display unit 16 is formed on the pressure-sensitive adhesive layer. The transmission suppression layer 30 contains the material that absorbs the wavelength in the visible light range. Further, the transmission suppression layer 30 is protected by the coating layer. The seal member 40 is attached to form the transmission suppression layer 30 in the region corresponding to the display unit 16.

In the example illustrated in Fig. 11, the transmission suppression layers 30A, 30B, 30C, and 30D having shapes in which the characters "ABCD" shown by the display unit 16 are inverted are formed. The seal member 40 is attached to the inner surface 22A1 of the first member 22 of the exterior body 12. In this way, the transmission of the emission light L in the region corresponding to the display unit 16 is suppressed. As a result, the difference in the transmittance of the emission light L emitted from the light-emitting unit 26 is generated between the region corresponding to the display unit 16 and the region on the periphery.

As described so far, in the electronic apparatus 10 according to the present modification example, the transmission suppression layer 30 is formed by attaching the seal member 40. As a result, in a case in which the seal member 40 is attached, the transmission suppression layer 30 can be formed, which can contribute to reduction in manufacturing cost of the electronic apparatus 10.

It should be noted that, in the above-described embodiment, the form example is described in which the display unit 16 is provided on the upper surface 12A of the exterior body 12, but the present disclosed technology is not limited to this. The display unit 16 may be provided on other surfaces of the exterior body 12. In addition, a plurality of display units 16 may be provided on the surface of the exterior body 12.

In addition, in the above-described embodiment, the form example is described in which the three-dimensional shape of the display unit 16 protrudes rather than the periphery, but the present disclosed technology is not limited to this. For example, the three-dimensional shape of the display unit 16 may be a shape that is recessed rather than the periphery, and the periphery may be roughened and the display unit 16 may be a smooth surface.

In addition, in the above-described embodiment, the form example is described in which the transmission suppression layer 30 is formed by printing, but the present disclosed technology is not limited to this. For example, the transmission suppression layer 30 may be formed by being partially molded with a resin that is less likely to allow the transmission of the light, or may be formed by attaching a light shielding cover of a separate component to the inside of the exterior body 12.

In addition, in the above-described embodiment, the form example is described in which the transmission of the emission light L is suppressed in the region corresponding to the display unit 16, but the present disclosed technology is not limited to this. For example, an aspect may be adopted in which the transmission of the emission light L is promoted in the region corresponding to the display unit 16. Specifically, the transmission suppression layer 30 may be formed in a portion other than the region corresponding to the display unit 16, to promote the transmission of light in the region corresponding to the display unit 16. In this way, the difference in the light transmittance is generated between the region corresponding to the display unit 16 and the periphery.

In addition, in the above-described embodiment, the form example is described in which the stripe pattern having the periodic recessed and protruding portions is formed on the surface of the exterior body 12, but the present disclosed technology is not limited to this. The surface of the exterior body 12 may have a structure that enhances the designability other than the stripe pattern, or may be a smooth surface.

In addition, in the above-described embodiment, the form example is described in which the first member 22 and the second member 24 have a symmetrical shape in a cross-sectional view, but the present disclosed technology is not limited to this. For example, the first member 22 may include the side wall portion 22B, and the second member 24 may be a plate-like member. In such a case, an end surface of the side wall portion 22B is in contact with the peripheral edge of the second member 24.

In addition, in the above-described embodiment, the form example is described in which the exterior body 12 has a rectangular parallelepiped shape, but the present disclosed technology is not limited to this. For example, the exterior body 12 may have a square shape, a spherical shape, or a cylindrical shape.

In addition, in the above-described embodiment, the form example is described in which the electronic apparatus 10 is the mobile printer 11, but the present disclosed technology is not limited to this. The electronic apparatus 10 may be, for example, a portable electronic apparatus, such as an instant camera, a digital camera, a smartphone, a tablet terminal, a laptop computer, or a mobile battery. In addition, the electronic apparatus 10 may be a stationary electronic apparatus, such as a desktop computer, a printer, a television, or a display.

In addition, in the above-described embodiment, the form example is described in which the film F is a so-called instant film containing the photosensitive material, but the present disclosed technology is not limited to this. For example, printing paper containing a heat sensitive material may be used instead of the film F.

In addition, in the above-described embodiment, the form example is described in which the light-emitting unit 26 includes the LED light source, but the present disclosed technology is not limited to this. For example, the light-emitting unit 26 may include an organic electroluminescence (EL) element.

In addition, in the above-described embodiment, the form example is described in which the coating film 32 is thick as a whole in the side wall portion 22B, but the present disclosed technology is not limited to this. The coating film 32 on half of the side wall portion 22B on the second member 24 side may be thick.

In addition, in the above-described embodiment, the form example is described in which the coating film 32 is thin as a whole in the bottom plate portion 22A, but the present disclosed technology is not limited to this. The coating film 32 may be thin in an elliptical region including the transmission portion 36, or may be thin only in a region corresponding to the transmission portion 36.

In addition, in the above-described embodiment, the form example is described in which the substrate 34 of the first member 22 is formed of the translucent material, but the present disclosed technology is not limited to this. For example, the substrate 34 may be the transparent material. However, as described above, it is preferable that the substrate 34 is formed of the translucent material from the viewpoint that the appearance adjustment by the coating film 32 is facilitated.

In addition, in the above-described embodiment, the form example is described in which the second member 24 is formed of the resin of the non-transparent material, but the present disclosed technology is not limited to this. For example, the second member 24 may also have a configuration in which a coating film (for example, a coating film containing titanium oxide) is formed on a substrate of the translucent material. However, as described above, it is desirable that the second member 24 is formed of the non-transparent material from the viewpoint that the entry of the external light can be suppressed.

The above-described contents and the above-illustrated contents are detailed descriptions of portions related to the present disclosed technology, and are merely examples of the present disclosed technology. For example, the description of the configuration, the function, the operation, and the effect are the description of examples of the configuration, the function, the operation, and the effect of the portion according to the present disclosed technology. Therefore, it goes without saying that unnecessary portions may be deleted, new elements may be added, or replacements may be made with respect to the above-described contents and the above-illustrated contents within a range that does not deviate from the scope of the present disclosed technology. Further, the description of, for example, common technical knowledge that does not need to be particularly described to enable the implementation of the present disclosed technology is omitted in the above-described contents and the above-illustrated contents in order to avoid confusion and to facilitate the understanding of the portions related to the present disclosed technology.

In the present specification, "A and/or B" is synonymous with "at least one of A or B". That is, "A and/or B" may mean only A, only B, or a combination of A and B. In the present specification, the same concept as "A and/or B" also applies to a case in which three or more matters are expressed by association with "and/or".

All of the documents, the patent applications, and the technical standards described in the present specification are incorporated into the present specification by reference to the same extent as in a case in which the individual documents, patent applications, and technical standards are specifically and individually noted to be described by reference.

In regard to the embodiment described above, the following supplementary notes will be further disclosed.

### Supplementary Note 1

An electronic apparatus comprising: a light-emitting unit configured to emit light to an outside; and an exterior body including a first member that is a member having a transmission portion that allows transmission of the light emitted from the light-emitting unit and having a coating film on a surface, and a second member that is a member disposed adjacent to the first member and formed of a material having lower light transmittance than the first member, in which a thickness of the coating film in a contact portion between the first member and the second member is greater than a thickness of the coating film in the transmission portion.

### Supplementary Note 2

The electronic apparatus according to claim 1, in which the first member has a substrate, and the coating film is formed on a surface of the substrate.

### Supplementary Note 3

The electronic apparatus according to supplementary note 2, in which the substrate is formed of a translucent material.

### Supplementary Note 4

The electronic apparatus according to any one of supplementary notes 1 to 3, in which the first member has a bottom plate portion on which the transmission portion is formed and a side wall portion that is erected from a peripheral edge of the bottom plate portion toward the second member, and the side wall portion is the contact portion.

### Supplementary Note 5

The electronic apparatus according to any one of supplementary notes 1 to 4, in which the second member is formed of a non-transparent material.

### Supplementary Note 6

The electronic apparatus according to supplementary note 5, in which the non-transparent material is a resin material containing titanium oxide.

### Supplementary Note 7

The electronic apparatus according to any one of supplementary notes 1 to 6, in which the light-emitting unit includes an LED light source.

### Supplementary Note 8

The electronic apparatus according to any one of supplementary notes 1 to 7, in which the thickness of the coating film in the contact portion is 1.5 times or more the thickness in the coating film of the transmission portion.

### Supplementary Note 9

The electronic apparatus according to any one of supplementary notes 1 to 8, in which the electronic apparatus has a printer function, and a space in which a film containing a photosensitive material is accommodatable is formed in the second member.

## Claims

1. An electronic apparatus (10) comprising:
a light-emitting unit (26) configured to emit light to an outside; and
an exterior body (12) including
a first member (22) that is a member having a transmission portion (36) that allows transmission of the light emitted from the light-emitting unit (26) and having a coating film (32) on a surface, and
a second member (24) that is a member disposed adjacent to the first member (22) and formed of a material having lower light transmittance than the first member (22),
wherein a thickness of the coating film (32) in a contact portion between the first member (22) and the second member (24) is greater than a thickness of the coating film (32) in the transmission portion (36).

2. The electronic apparatus (10) according to claim 1,
wherein the first member (22) has a substrate (34), and
the coating film (32) is formed on a surface of the substrate (34).

3. The electronic apparatus (10) according to claim 2,
wherein the substrate (34) is formed of a translucent material.

4. The electronic apparatus (10) according to any one of claims 1 to 3,
wherein the first member (22) has a bottom plate portion (22A) on which the transmission portion (36) is formed and a side wall portion (22B) that is erected from a peripheral edge of the bottom plate portion (22A) toward the second member (24), and
the side wall portion (22B) is the contact portion.

5. The electronic apparatus (10) according to any one of claims 1 to 4,
wherein the second member (24) is formed of a non-transparent material.

6. The electronic apparatus (10) according to claim 5,
wherein the non-transparent material is a resin material containing titanium oxide.

7. The electronic apparatus (10) according to any one of claims 1 to 6,
wherein the light-emitting unit (26) includes an LED light source (26A-26C).

8. The electronic apparatus (10) according to any one of claims 1 to 7,
wherein the thickness of the coating film (32) in the contact portion is 1.5 times or more the thickness of the coating film (32) in the transmission portion (36).

9. The electronic apparatus (10) according to any one of claims 1 to 8,
wherein the electronic apparatus has a printer function, and
a space in which a film (F) containing a photosensitive material is accommodatable is formed in the second member (24).

10. A method of manufacturing an electronic apparatus including a light-emitting unit (26) configured to emit light to an outside, and an exterior body (12) including a first member (22) that is a member having a transmission portion (36) that allows transmission of the light emitted from the light-emitting unit (26) and having a coating film (32) on a surface, and a second member (24) that is a member disposed adjacent to the first member (22) and formed of a material having lower light transmittance than the first member (22), the method comprising:
preparing the first member (22); and
providing the coating film (32) in the first member (22) at a contact portion with the second member (24) to be thicker than the coating film (32) in the transmission portion (36).
